# EUROPÄISCHE PATENTSCHRIFT

(11) **EP 3 451 535 B1**
(45) Veröffentlichungstag und Bekanntmachung des Hinweises auf die Patenterteilung: **11.10.2023**
(21) Anmeldenummer: 18184554.6
(22) Anmeldetag: 19.07.2018
(51) Int. Cl.: H03K 17/955, E05F 15/46, E05F 15/73

(54) **SENSORVORRICHTUNG ZUR KAPAZITIVEN ERFASSUNG EINER BENUTZERHANDLUNG BEI EINEM FAHRZEUG**
SENSOR DEVICE FOR CAPACITIVE DETECTION OF USER ACTION IN A VEHICLE
DISPOSITIF CAPTEUR DESTINÉ À LA DÉTECTION CAPACITIVE D'UNE MANIPULATION UTILISATEUR SUR UN VÉHICULE

(30) Priorität: 05.09.2017 DE 102017120375
(43) Veröffentlichungstag der Anmeldung: 06.03.2019
(73) Patentinhaber: Huf Hülsbeck & Fürst GmbH & Co. KG, 42551 Velbert (DE)
(72) Erfinder: Schindler, Mirko, 42549 Velbert (DE); Lindic, Iko, 45149 Essen (DE)
(74) Vertreter: Bals & Vogel Patentanwälte PartGmbB

(56) Entgegenhaltungen:
- DE-A1-102013 015 644
- DE-A1-102015 003 320
- DE-U1-202010 011 656
- US-A1- 2005 092 097

## Beschreibung

Die vorliegende Erfindung betrifft eine Sensorvorrichtung gemäß der im Oberbegriff des Anspruchs 1 näher definierten Art. Ferner bezieht sich die Erfindung auf ein System gemäß dem Oberbegriff des Anspruchs 11, ein Fahrzeug sowie ein Verfahren zum Betreiben einer kapazitiven Sensorvorrichtung bei einem Fahrzeug.

Sensorvorrichtungen zur kapazitiven Erfassung einer Benutzerhandlung bei einem Fahrzeug werden im Stand der Technik bspw. im Heckbereich eines Fahrzeuges eingesetzt. Es kann bspw. ein Sensorelement sich im Bereich eines Stoßfängers erstrecken, um eine Bewegung eines Benutzers als Benutzerhandlung zu erfassen. Z. B. wird hierdurch eine Fußbewegung detektiert, welche zur Öffnung einer Hecklappe des Fahrzeuges führt.

Dabei ist es bekannt, dass zur Erfassung der Benutzerhandlung eine kapazitive Auswertung der Sensorvorrichtung erfolgt. Eine Kapazitätsveränderung bei der Sensorvorrichtung deutet hierbei auf die Benutzerhandlung hin, und wird durch eine Auswertevorrichtung des Fahrzeuges gemessen.

In DE102015003320A1 wird eine solche Erfassung offenbart.

Für die zuverlässige und korrekte Erfassung der Benutzerhandlung ist daher eine elektrische Verbindung der Auswertevorrichtung mit einem Sensorelement der Sensorvorrichtung notwendig. Oft kann dabei bei bekannten Lösungen eine fehlerhafte Verbindung nur unzureichend oder gar nicht erfasst werden. Des Weiteren sind bekannte Lösungen oft mit einem hohen technischen Aufwand verbunden, was zusätzlich die Kosten für die Sensorvorrichtung erhöht.

Es ist daher eine Aufgabe der vorliegenden Erfindung, die voranstehend beschriebenen Nachteile zumindest teilweise zu beheben. insbesondere ist es eine Aufgabe der vorliegenden Erfindung, eine technisch vereinfachte und/oder kostengünstigere Möglichkeit zum zuverlässigen Betreiben einer Sensorvorrichtung bei gleichzeitiger guter Handhabbarkeit bereitzustellen.

Die voranstehende Aufgabe wird gelöst durch eine Sensorvorrichtung mit den Merkmalen des unabhängigen Vorrichtungsanspruchs 1 sowie durch ein Verfahren mit den Merkmalen des unabhängigen Verfahrensanspruchs 14. Weitere Merkmale und Details der Erfindung ergeben sich aus den jeweiligen Unteransprüchen, der Beschreibung und den Zeichnungen. Dabei gelten Merkmale und Details, die im Zusammenhang mit der erfindungsgemäßen Sensorvorrichtung beschrieben sind, selbstverständlich auch im Zusammenhang mit dem erfindungsgemäßen System, dem erfindungsgemäßen Fahrzeug sowie dem erfindungsgemäßen Verfahren und jeweils umgekehrt, sodass bezüglich der Offenbarung zu den einzelnen Erfindungsaspekten stets wechselseitig Bezug genommen wird bzw. werden kann.

Die Aufgabe wird insbesondere gelöst durch eine Sensorvorrichtung zur kapazitiven Erfassung einer Benutzerhandlung, vorzugsweise einer Annäherung und/oder Geste, bei einem Fahrzeug. Zum Beispiel kann eine Annäherung und/oder ein Bewegungsverlauf, wie eines Beins oder eines Fußes eines Benutzers beim Fahrzeug, erfasst werden. Dies kann Vorteile haben, wenn die Sensorvorrichtung, und insbesondere ein Sensorelement, im Heck- und/oder Seitenbereich des Fahrzeuges, z. B. unterhalb einer Heckklappe und/oder unterhalb der (Schiebe-) Türen und/oder im Bereich eines Stoßfängers und/oder innerhalb des Stoßfängers, angeordnet ist. In Falle einer Anordnung im Heckbereich kann die Sensorvorrichtung als ein sogenannter "Kick-Sensor" ausgebildet sein, dessen Detektion der Benutzerhandlung zu einem motorisierten Öffnungsvorgang der Heckklappe führt. Dadurch ist eine deutliche Komfortsteigerung bei der Fahrzeugbedienung möglich.

Gemäß einem weiteren Vorteil kann es vorgesehen sein, dass durch die Sensorvorrichtung ein Überwachungsbereich im Seiten- und/oder Heckbereich des Fahrzeuges überwacht wird, um eine Annäherung und/oder eine Bewegung als Benutzerhandlung im Überwachungsbereich zu detektieren. Dabei kann zur Steigerung der Sicherheit vor und/oder bei und/oder nach der erfolgreichen Detektion eine Authentifizierung erfolgen, z. B. über Funk mit einem Identifikationsgeber (ID-Geber) durch einen Codeaustausch oder dergleichen. Entsprechend kann eine Funktion des Fahrzeuges, wie ein Öffnen der Heckklappe, nur dann bei erfolgreicher Detektion aktiviert werden, wenn die Authentifizierung erfolgreich ist.

Es kann des Weiteren wenigstens ein Sensorelement vorgesehen sein und am Fahrzeug, z. B. am Seiten- und/oder Heckbereich, vorzugsweise in einem Stoßfänger und/oder im Bereich eines Türschwellers, angeordnet sein. Das Sensorelement ist vorteilhafterweise als elektrisches Leitungselement, wie z. B. ein Kabel, ausgeführt und kann somit eine längliche Erstreckung aufweisen. Auch kann das Sensorelement als Sensorelektrode ausgebildet sein, welche vorzugsweise nur einseitig (an einem Ende) elektrisch mit dem Fahrzeug bzw. der Auswertevorrichtung verbunden ist, sodass ggf. die gegenüberliegende Seite (das andere Ende in axialer Richtung) potentialfrei (floating) und/oder elektrisch unverbunden und/oder elektrisch vollständig isoliert ausgebildet ist.

Gemäß einem weiteren Vorteil umfasst das Sensorelement zumindest einen der nachfolgenden Komponenten:
- ein elektrisch leitendes (d. h. zumindest teilweise leitfähiges) Außenleiterelement, und ggf. auch ein elektrisch leitendes (d. h. zumindest teilweise leitfähiges) Innenleiterelement, welche bevorzugt konzentrisch zueinander angeordnet sind, und besonders bevorzugt das Außenleiterelement das Innenleiterelement in radialer Ebene bzw. in Umfangsrichtung vollständig umgibt,
- wenigstens ein Isolationselement zur elektrischen Isolierung des Außenleiterelements und/oder des Innenleiterelements, welche bevorzugt konzentrisch zueinander und/oder zu dem Außen- und/oder Innenleiterelement angeordnet sind,
- eine Auswerteverbindungsanpassung an dem Außenleiterelement zur elektrisch leitenden Verbindung des Außenleiterelements mit einer Auswertevorrichtung des Fahrzeuges, wodurch die Erfassung durchführbar ist.

Hierbei ist gemäß einem Vorteil der Erfindung vorgesehen, dass eine Prüfverbindungsanpassung an dem Außenleiterelement angeordnet ist, um einen Funktionstest der Sensorvorrichtung anhand eines elektrischen Stromkreises mit dem Außenleiterelement zu prüfen. In anderen Worten kann durch die Prüfverbindungsanpassung ein Stromkreis gebildet werden, welcher auch das Außenleiterelement umfasst. Es kann hierdurch eine besonders einfache, zuverlässige und kostengünstige Prüfung der Sensorvorrichtung bereitgestellt werden, um als Funktionstest bspw. eine korrekte elektrische Verbindung des Sensorelements mit der Auswertevorrichtung zu prüfen. Eine solche Prüfung ist notwendig, da ggf. nur anhand der Auswerteverbindungsanpassung nicht zwischen einer ausbleibenden Erfassung (d. h. einer ausbleibenden Detektion der Benutzerhandlung) und einer fehlerhaften elektrischen Verbindung unterschieden werden kann. So kann es vorgesehen sein, dass ein Ergebnis der Auswertung der Auswertevorrichtung über die Auswerteverbindungsanpassung in einem Zustand, in welchem keinerlei Benutzerhandlung vorliegt und damit nicht erfasst wird, zumindest nahezu identisch und damit nicht unterscheidbar ist zu einem Zustand, in welchem die elektrische Verbindung fehlerhaft und/oder unterbrochen ist.

Ferner ist es optional möglich, dass die Auswerteverbindungsanpassung ausschließlich eine Verbindungsstelle und/oder ausschließlich einen elektrischen Leiter umfasst, sodass beim normalen Betrieb der Sensorvorrichtung zur Erfassung der Benutzerhandlung ausschließlich eine elektrisch leitende Verbindung mit ausschließlich einem Verbindungspfad zwischen der Auswertevorrichtung und dem Sensorelement genutzt wird (und somit kein ununterbrochener geschlossener Stromkreis zwischen der Auswertevorrichtung und dem Sensorelement genutzt wird). In anderen Worten wird zur kapazitiven Erfassung der Benutzerhandlung ausschließlich die Auswerteverbindungsanpassung durch die Auswertevorrichtung genutzt, sodass lediglich ein einziger elektrischer Leiter von der Auswertevorrichtung zur Auswerteverbindungsanpassung führt und/oder zur Erfassung der Benutzerhandlung genutzt wird. Dagegen kann zum Funktionstest ein geschlossener und/oder ununterbrochener (d. h. ohne Dielektrikum) Stromkreis genutzt werden, in dem zwei elektrische Leiter über die Prüfverbindungsanpassung zur Auswertevorrichtung führen. Dies hat den Vorteil, dass eine konstruktiv besonders einfache Umsetzung der Sensorvorrichtung möglich ist.

Ein weiterer Vorteil ergibt sich, wenn die Prüfverbindungsanpassung lediglich an einem Ende des Sensorelements am Außenleiterelement angeordnet ist, sodass der Stromkreis zum Funktionstest lediglich einseitig bzw. an einem Ende des Sensorelements angeordnet ist. Mit anderen Worten wird zum Funktionstest keine Durchgangsprüfung zwischen einem Ende und dem anderen Ende (in axialer Richtung) am Außenleiterelement durchgeführt. Somit wird die Prüfung einer korrekten elektrischen Kopplung zwischen dem Sensorelement und der Auswertevorrichtung stark vereinfacht.

Um eine Benutzerhandlung zu erfassen, wird das Sensorelement z. B. kapazitiv durch die Auswertevorrichtung über die Auswerteverbindungsanpassung ausgewertet. Hierzu kann z. B. ein Umladeverfahren zum Einsatz kommen, bei welchem durch wiederholte Ladevorgänge eine Kapazitätsänderung gemessen wird. Hierzu kann bspw. eine Kapazität wiederholt geladen werden und eine Veränderung dieser Kapazität ermittelt werden, wobei sich die Kapazität z. B. zwischen dem Sensorelement und der Umgebung, wie einem Benutzer, z. B. einem Fuß des Benutzers, einstellt. Ein Vorliegen der Benutzerhandlung wird z. B. durch eine signifikante Kapazitätsänderung indiziert, wobei hierzu z. B. ein Schwellenwert vordefiniert wird, welcher durch die Kapazitätsänderung überschritten werden muss, damit die Benutzerhandlung positiv detektiert wird. Umgekehrt kann eine ausbleibende Kapazitätsänderung ein Ausbleiben der Benutzerhandlung indizieren. In gleicher Weise kann ein Ausbleiben der Kapazitätsveränderung aber auch in einer fehlerhaften elektrischen Verbindung zwischen der Auswertevorrichtung und der Auswerteverbindungsanpassung begründet sein. Daher wird ein besonderer Vorteil erzielt, wenn eine weitere Prüfverbindungsanpassung genutzt wird, um die elektrische Verbindung zu prüfen.

Die Auswerteverbindungsanpassung kann bspw. Teil der Prüfverbindungsanpassung sein, sodass bspw. eine elektrische Verbindungsstelle der Auswerteverbindungsanpassung sowohl zur Erfassung als auch zur Prüfung (zum Funktionstest) genutzt wird. Vorteilhaft kann es sein, wenn die Auswerteverbindungsanpassung eine erste elektrische Verbindungsstelle am Sensorelement aufweist und die Prüfverbindungsanpassung die erste elektrische Verbindungsstelle und wenigstens eine zweite elektrische Verbindungsstelle aufweist. Damit wird ein besonders kostengünstiger und konstruktiv einfacher Aufbau der Prüfverbindungsanpassung bereitgestellt, weil die erste Verbindungsstelle sowohl für die Prüfung als auch für die Auswertung genutzt werden kann.

In einer weiteren Möglichkeit kann es vorgesehen sein, dass die Auswerteverbindungsanpassung wenigstens oder ausschließlich einen ersten elektrischen Leiter aufweist, um die Auswertevorrichtung mit dem Außenleiterelement zur Auswertung der Erfassung zu verbinden, und die Prüfverbindungsanpassung wenigstens oder ausschließlich einen zweiten elektrischen Leiter und den ersten Leiter aufweist, um die Auswertevorrichtung mit dem Außenleiterelement zu verbinden und den Stromkreis zur Durchführung des Funktionstests bereitzustellen. Hierbei können die geschilderten Verbindungen zwischen der Auswertevorrichtung und dem Außenleiterelement dauerhaft bestehen, sodass sowohl die Erfassung als auch der Funktionstest stets durchführbar sind. Bspw. ist der erste elektrische Leiter mit einer ersten Verbindungsstelle und der zweite elektrische Leiter mit einer zweiten Verbindungsstelle der Prüfverbindungsanpassung verbunden. Auch kann es möglich sein, dass der erste und/oder zweite elektrische Leiter jeweils mehrere elektrische Leitmittel, wie z.B. Drähte oder Litzen, aufweist. Dies ermöglicht es, z.B. ein Drahtgeflecht des Außenleiterelements in vereinfachter Weise in Verbindung mit der Auswertevorrichtung zu nutzen.

Des Weiteren ist es denkbar, dass die Prüfverbindungsanpassung zumindest ein Verbindungsmittel, vorzugsweise einen Crimpverbinder, aufweist, um das Außenleiterelement elektrisch mit der Auswertevorrichtung zu verbinden, sodass durch die Auswertevorrichtung der Funktionstest durchführbar ist, wobei vorzugsweise der Funktionstest als eine Verbindungsprüfung ausgeführt ist. Bspw. kann wenigstens ein Leitermittel, wie ein Draht und/oder eine Litze, form- und/oder kraftschlüssig mit dem Crimpverbinder verbunden sein, um die elektrische Verbindung zur Auswertevorrichtung herzustellen. Bspw. kann hierbei ein Crimpverbinder für jede der Verbindungsstellen bzw. jeder der Leiter genutzt werden. Dies ermöglicht eine zuverlässige und einfache mechanische Verbidung.

Ein weiterer Vorteil wird im Rahmen der Erfindung erzielt, da das Sensorelement ein elektrisch leitendes Innenleiterelement aufweist und vorzugsweise das wenigstens eine Isolationselement das Innenleiterelement zur elektrischen Isolierung (z. B. in Umfangsrichtung) umgibt. Erfindungsgemäß ist dabei das Innenleiterelement vollständig und allseits elektrisch isoliert und ist somit vollständig und allseits elektrisch unverbunden.

Bspw. ist das Innenleiterelement als Seele des als Kabel ausgebildeten Sensorelements ausgebildet, und umfasst bspw. wenigstens eine Litze und/oder ausschließlich einen elektrisch leitfähigen Draht. Bevorzugt hat dabei das Innenleiterelement in axialer Richtung (d. h. Längsrichtung des Sensorelements) die gleiche Länge wie das Außenleiterelement und/oder das Isolationselement. Ein wichtiger Vorteil der Nutzung des Innenleiterelements ist, dass sich hierdurch die Handhabung und/oder Herstellung des Sensorelements deutlich vereinfachen lässt. So kann bspw. der Extrusionsprozess verbessert werden und/oder die Montage des Sensorelements im Fahrzeug, z. B. der Einbau und/oder die Ausrichtung in einem Stoßfänger vereinfacht werden. Hierzu kann das Innenleiterelement auch eine plastische Verbiegbarkeit aufweisen, um die längliche Erstreckung des Sensorelements zu beeinflussen. Bspw. weist dabei das Innenleiterelement Kupfer oder Silber auf, um eine elektrische Leitfähigkeit und/oder höhere Stabilität bereitzustellen.

Es kann ferner möglich sein, dass das Sensorelement als elektrisches Kabel ausgebildet ist und vorzugsweise ein Innenleiterelement als Seele und das Außenleiterelement als Schirm aufweist. Vorteilhafter Weise ist dabei das Sensorelement als Sensorelektrode ausgebildet, sodass sich durch den, insbesondere koaxialen, Aufbau des Innenleiterelements und Außenleiterelements besondere mechanische und elektrische Vorteile ausbilden. Bspw. dient dabei die Umgebung des Sensorelements als Dielektrikum zu einer weiteren Art Elektrode, wie dem Benutzer, wenn die Benutzerhandlung durchgeführt wird.

Gemäß einer weiteren Möglichkeit kann das Außenleiterelement wenigstens einen separat vom Innenleiterelement ausgebildeten elektrischen Leiter aufweisen, vorzugsweise aus einem elektrisch leitenden Metall oder Kunststoff.

Optional ist es denkbar, dass das Außenleiterelement als ein Drahtgeflecht ausgebildet ist. Insbesondere kann dabei das Außenleiterelement ein Innenleiterelement des Sensorelements in Umfangsrichtung vollständig umgeben. Hierdurch kann die nutzbare Sensorfläche deutlich vergrößert werden und damit die Erfassung der Benutzerhandlung verbessert werden.

Vorteilhaft ist es darüber hinaus, wenn im Rahmen der Erfindung das Sensorelement einen konzentrischen Aufbau aufweist, wobei vorzugsweise das Außenleiterelement koaxial zu einem Innenleiterelement des Sensorelements angeordnet ist. Bspw. kann dabei zwischen dem Außenleiterelement und dem Innenleiterelement das wenigstens eine Isolationselement bzw. eines der Isolationselemente angeordnet sein, um das Außenleiterelement elektrisch vom Innenleiterelement zu isolieren. Hierzu ist das Isolationselement bspw. aus einem elektrisch isolierenden Material, wie bspw. einem Kunststoff, ausgebildet. Somit können elektrische Störungen bei der Erfassung der Benutzerhandlung vermieden werden.

Zudem ist im Rahmen der Erfindung denkbar, dass das Isolationselement ein erstes Isolationselement, insbesondere für das Innenleiterelement, und ein zweites Isolationselement, insbesondere für das Außenleiterelement, aufweist, welche konzentrisch angeordnet sind. Hierdurch können elektrische und/oder mechanische Eigenschaften des Sensorelements verbessert werden.

Ein weiterer Vorteil kann im Rahmen der Erfindung erzielt werden, wenn das Sensorelement eine längliche Erstreckung entlang einer Längsachse zwischen einem ersten Ende, welches vorzugsweise der Auswertevorrichtung zugewandet ist, und einem zweiten Ende, welches vorzugsweise der Auswertevorrichtung abgewandt ist, aufweist, und insbesondere die Prüfverbindungsanpassung und/oder Auswerteverbindungsanpassung ausschließlich an einem der Enden am Sensorelement vorgesehen sind, und bevorzugt ein erster Leiter und ein zweiter Leiter nur an einem der Enden mit dem Außenleiterelement verbunden sind, sodass bevorzugt das zweite Ende als freies Ende elektrisch unverbunden, besonders bevorzugt potentialfrei, ist. Dies ist insbesondere aus dem Grunde vorteilhaft, da das Sensorelement nicht als Schlaufe mit der Auswertevorrichtung verbunden sein muss, und somit eine flexiblere Anordnung im Fahrzeug möglich ist.

Des Weiteren ist es denkbar, dass das Außenleiterelement und vorzugsweise ein Innenleiterelement sich entlang der länglichen Erstreckung des Sensorelements erstrecken, sodass bevorzugt das Innenleiterelement und das Außenleiterelement parallel zueinander verlaufen. Dies vereinfacht die Herstellung und Handhabung des Sensorelements deutlich.

Eine Ausführungsform der Erfindung ist ein System zur kapazitiven Erfassung einer Benutzerhandlung bei einem Fahrzeug nach Anspruch 9.

Hierbei ist es insbesondere möglich, dass eine Prüfverbindungsanpassung an dem Außenleiterelement vorgesehen ist, um einen Funktionstest der Sensorvorrichtung anhand eines elektrischen Stromkreises mit dem Außenleiterelement zu prüfen. Damit bringt das erfindungsgemäße System die gleichen Vorteile mit sich, wie sie ausführlich mit Bezug auf eine erfindungsgemäße Sensorvorrichtung beschrieben worden sind. Zudem kann das System eine erfindungsgemäße Sensorvorrichtung aufweisen.

Ein weiterer Vorteil ist im Rahmen des erfindungsgemäßen Systems erzielbar, wenn die Auswertevorrichtung als Steuergerät des Fahrzeuges und/oder als Microcontroller und/oder als integrierter Schaltkreis ausgebildet ist. Bspw. kann die Auswertevorrichtung mit einer zentralen Fahrzeugelektronik verbunden sein oder Teil der zentralen Fahrzeugelektronik sein, um bspw. eine Authentifizierung durchzuführen. Bspw. kann auch ein Datenaustausch zwischen der Auswertevorrichtung und der zentralen Fahrzeugelektronik vorgesehen sein. Dies ermöglicht es, die kapazitive Erfassung der Sensorvorrichtung in vielseitiger Weise für das Fahrzeug zu nutzen.

Optional kann es vorgesehen sein, dass eine elektrische Verbindungsschnittstelle, vorzugsweise ein Stecker, elektrisch mit der Auswertevorrichtung verbunden ist und ein erster und zweiter Leiter des Außenleiterelements über die Verbindungsschnittstelle mit der Auswertevorrichtung elektrisch verbunden sind. Bspw. kann die Verbindungsschnittstelle ein Gehäuse aufweisen, welches elektrisch isolierend ausgebildet ist. Dies ermöglicht eine vereinfachte Montage zur Herstellung der Verbindung zwischen der Auswertevorrichtung und dem Außenleiterelement.

Vorteilhafterweise kann im Rahmen der Erfindung vorgesehen sein, dass ein erster Leiter benachbart zu einem zweiten Leiter mit dem Außenleiterelement elektrisch verbunden ist, insbesondere in einem Abstand von maximal 1 mm bis 40 mm, vorzugsweise 2 mm bis 30 mm , bevorzugt 5 mm bis 20 mm, wodurch das Außenleiterelement in einen Strompfad seriell zum ersten und zweiten Leiter integriert ist. Somit kann die Montage der Sensorvorrichtung deutlich vereinfacht werden, da lediglich einseitig und in unmittelbarer Nähe am Sensorelement die Verbindungen zur Herstellung des Strompfades hergestellt werden müssen. Ein Kerngedanke ist hierbei, dass keine vollständige Durchgangsprüfung (in axialer Richtung) des Sensorelements durchgeführt werden muss, sondern eine einseitige Ausbildung eines Stromkreises an einem Ende des Sensorelements ausreichend ist.

Eine Ausführungsform der Erfindung ist ein Fahrzeug nach Anspruch 12.

Damit bringt das erfindungsgemäße Fahrzeug die gleichen Vorteile mit sich, wie sie ausführlich mit Bezug auf ein erfindungsgemäßes System und/oder eine erfindungsgemäße Sensorvorrichtung beschrieben worden sind.

Ferner ist es denkbar, dass das Sensorelement in einem Stoßfänger des Fahrzeuges angeordnet ist, um eine Fußbewegung eines Benutzers im Heckbereich des Fahrzeuges zu erfassen. Alterativ oder zusätzlich kann das Sensorelement im Bereich eines Türschwellers des Fahrzeuges angeordnet sein, um eine Fußbewegung eines Benutzers im Seitenbereich des Fahrzeuges zu erfassen. Bspw. dient diese Erfassung zur Aktivierung einer Öffnungsbewegung einer Heckklappe bzw. einer Schiebetür des Fahrzeuges.

Ebenfalls Gegenstand der Erfindung ist ein Verfahren zum Betreiben einer kapazitiven Sensorvorrichtung nach Anspruch 14.

Damit bringt das erfindungsgemäße Verfahren die gleichen Vorteile mit sich, wie sie ausführlich mit Bezug auf ein erfindungsgemäßes System und/oder eine erfindungsgemäße Sensorvorrichtung beschrieben worden sind.

Optional kann es möglich sein, dass die Schritte des erfindungsgemäßen Verfahrens bei jedem Motorstart durchgeführt werden, um den Funktionstest durchzuführen. Es ist dabei denkbar, dass bei einem fehlerhaften Funktionstest eine Warnmeldung an einen Benutzer des Fahrzeuges ausgegeben wird, z. B. im Bereich einer Instrumententafel und/oder eines Kombiinstrumentes eines Fahrzeuges. Alternativ oder zusätzlich kann es möglich sein, dass bei einem fehlerhaften Funktionstest eine Protokollierung des Fehlers stattfindet, bspw. auch ohne einen Hinweis an den Benutzer auszugeben.

Vorzugsweise kann vorgesehen sein, dass der nachfolgende Schritt vor dem Durchführen der Verbindungsprüfung vorgesehen ist:
- Verbinden des Sensorelements der Sensorvorrichtung über eine Verbindungsschnittstelle mit einer Auswertevorrichtung des Fahrzeuges.

Insbesondere kann dieser Schritt ein Montageschritt bei der Montage der Sensorvorrichtung sein.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Es zeigen jeweils schematisch:
- Figur 1: verschiedene Ansichten eines erfindungsgemäßen Fahrzeuges.
- Figur 2: eine Darstellung einer erfindungsgemäßen Sensorvorrichtung,
- Figur 3: eine schematische Darstellung eines Querschnitts eines Sensorelements, einer erfindungsgemäßen Sensorvorrichtung und eines erfindungsgemäßen Systems.

In den nachfolgenden Figuren werden für die gleichen technischen Merkmale auch von unterschiedlichen Ausführungsbeispielen die identischen Bezugszeichen verwendet.

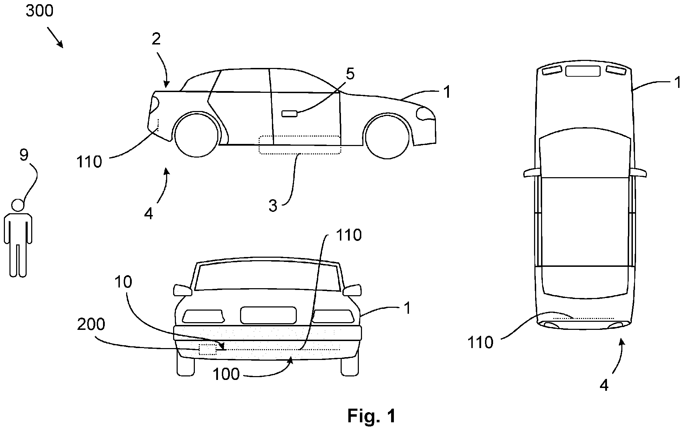

In Figur 1 sind schematisch verschiedene Ansichten eines Fahrzeuges 1 gezeigt, eine Seitenansicht (oben links), eine Rückansicht (unten links) sowie eine Draufsicht (rechts). Des Weiteren sind Teile eines erfindungsgemäßen Systems 300 gezeigt, welches zur kapazitiven Erfassung einer Benutzerhandlung eines Benutzers 9 dient. Eine solche Benutzerhandlung kann bspw. eine Bewegung im Bereich eines Stoßfängers 4 im Heckbereich des Fahrzeuges 1 und/oder im Bereich eines Türschwellers 3 im Seitenbereich des Fahrzeuges 1 sein. Bspw. dient die Benutzerhandlung dazu, eine Öffnungsbewegung, z. B. einer Heckklappe 2 des Fahrzeuges 1 auszulösen.

Um die Benutzerhandlung des Benutzers 9 zu erfassen, kann eine Sensorvorrichtung 100 des erfindungsgemäßen Systems 300 am Fahrzeug 1 vorgesehen sein. Hierzu ist bspw. ein Sensorelement 110 der Sensorvorrichtung 100 im Stoßfänger 4 und/oder im Schweller 3 angeordnet. Alternativ oder zusätzlich kann das Sensorelement 110 auch in einem Türgriff 5 angeordnet sein und somit bspw. als Näherungssensor zur Entriegelung genutzt werden. Deutlich erkennbar ist in Figur 1 ist die längliche Erstreckung des Sensorelements 110, welches auch als Kabel ausgeführt sein kann. Um die Erfassung durchzuführen, ist ein Steuergerät 200 vorgesehen und elektrisch mit dem Sensorelement 110 verbunden. Des Weiteren kann für einen Funktionstest eine Prüfverbindung zwischen dem Steuergerät 200 und dem Sensorelement 110 genutzt werden, wobei die Prüfverbindung durch eine Prüfverbindungsanpassung 10 des Sensorelements 110 ermöglich wird.

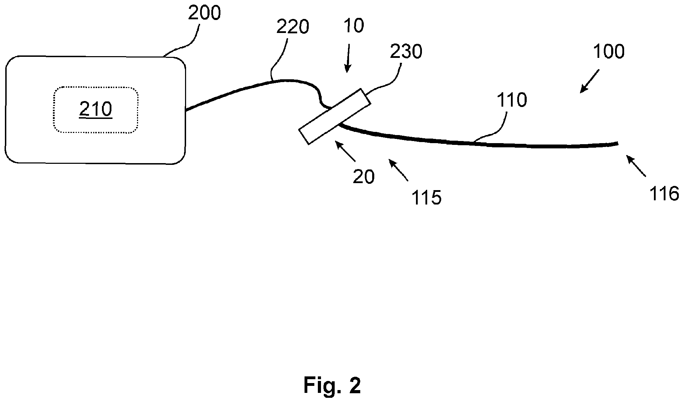

In Figur 2 ist die Verbindung zwischen dem Steuergerät 200 und dem Sensorelement 110 mit weiteren Einzelheiten schematisch dargestellt. So ist es erkennbar, dass das Steuergerät 200 eine Auswertevorrichtung 210, wie einen Microcontroller, aufweisen kann. Diese muss zur Erfassung sowie zum Funktionstest elektrisch mit dem Sensorelement 110 (ausschließlich) an einem ersten Ende 115 des Sensorelements 110 verbunden sein. Ein weiteres gegenüberliegendes Ende 116 kann dabei unverbunden bzw. potenzialfrei ausgeführt sein (als freies Ende 116). Für die Verbindung verläuft ggf. eine Steuergeräteleitung 220 von dem Steuergerät 200 zu einem Stecker 230. Um die Verbindung mit dem Stecker 230 herzustellen, kann die Prüfverbindungsanpassung 10 am Sensorelement 110 vorgesehen sein. Des Weiteren kann ein Teil der Prüfverbindungsanpassung 10 als Auswerteverbindungsanpassung 20 ausgeführt sein, welche eine elektrisch leitende Verbindung zwischen der Auswertevorrichtung 210 und dem Sensorelement 110 zur Erfassung der Benutzerhandlung bereitstellt.

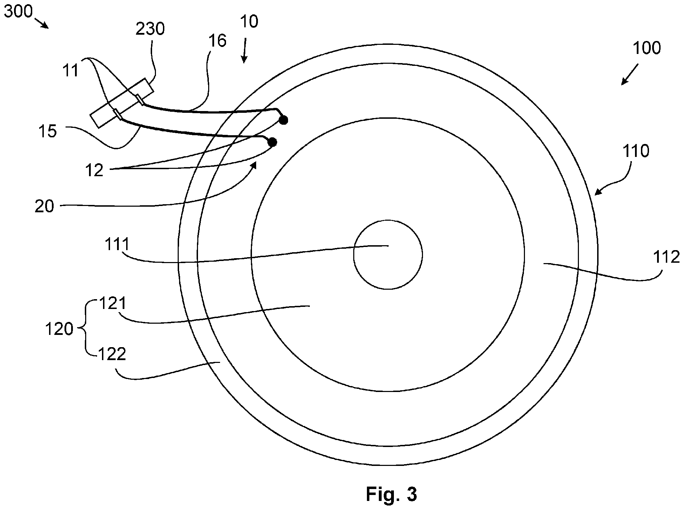

Figur 3 verdeutlicht diesen Aufbau schematisch. Dabei ist ein Querschnitt des Sensorelements 110 gezeigt, welches ein Innenleiterelement 111 (als Seele 111), ein Außenleiterelement 112 (als Schirm 112), sowie ein dazwischen angeordnetes erstes Isolationselement 121 aufweist. Optional kann ein zweites Isolationselement 122, insbesondere als Schutzmantel bzw. Ummantelung 122 des Sensorelements 110, an einem äußerstem Umfang des Sensorelements 110 angeordnet sein. Das wenigstens eine Isolationselement 120 dient dabei zur Verbesserung der Sensoreigenschaften des Sensorelements 110. Insbesondere dient dabei das erste Isolationselement 121 zur Abschirmung des Innenleiterelements 111 von dem Außenleiterelement 112.

Von Vorteil ist es, wenn die Sensorvorrichtung 100 als kapazitiver Abstandssensor 100 ausgeführt ist und das Sensorelement 110 bspw. eine Sensorelektrode bildet. Insbesondere bildet dabei das Außenleiterelement 112, vorzugsweise ausschließlich das Außenleiterelement 112, eine aktive Sensorfläche der Sensorvorrichtung 100. Das (erste) Isolationselement 121 ist bspw. als ein zylindrischer Trägerkörper aus einem elektrisch nicht leitenden Material ausgebildet, und weist bevorzugt eine runde Querschnittsfläche auf und ist besonders bevorzugt aus einem Vollmaterial ausgebildet. Es kann vorgesehen sein, dass das Außenleiterelement 112 das (erste) Isolationselement 121 nach Art eines Mantels umfänglich umgibt und/oder aus Vollmaterial besteht. Von weiterem Vorteil ist das erste Isolationselement 121 vollständig separat und/oder beabstandet vom zweiten Isolationselement 122 ausgebildet.

Hier ist es besonders vorteilhaft, wenn das Innenleiterelement 111 nicht nur in Umfangsrichtung vom Isolationselement 120 umgeben ist, sondern ggf. allseits isoliert ist oder zumindest allseits elektrisch unverbunden ist. Bspw. kann die einzige elektrische Verbindung des Sensorelements 110 mit einer Fahrzeugelektronik, wie der Auswertevorrichtung 210, durch die gezeigten elektrischen Leiter, also dem ersten Leiter 15 und dem zweiten Leiter 16 bereitgestellt werden. Die Leiter 15, 16 betreffen dabei die jeweiligen Strompfade, können somit also auch aus mehreren Leitermitteln (wie z. B. Drähte oder Litzen) hergestellt sein. Die Prüfverbindungsanpassung 10 kann z. B. die gezeigten Verbindungsstellen 12 aufweisen, welche zwei Punkte eines Stromkreises, insbesondere Strompfades, durch das Außenleiterelement 112 bilden. Über den Stecker 230 kann dann eine Verbindung mit der Auswertevorrichtung 210 hergestellt werden, um diesen Stromkreis zu schließen. Insbesondere wird dabei der Stromkreis bei dem Funktionstest geschlossen, sodass ein Strom durch den ersten Leiter 15 über das Außenleiterelement 112 und dann durch den zweiten Leiter 16 fließen kann. Damit kann zuverlässig festgestellt werden, ob die Verbindung an den Verbindungstellen 12 funktionsgerecht vorliegt. Die Verbindung zur Auswertevorrichtung 210 kann im Bereich des Steckers 230 bspw. über Verbindungsmittel, vorzugsweise Crimpverbinder 11, hergestellt werden. Hierzu wird bspw. wenigstens ein Draht und/oder wenigstens eine Litze des Außenleiters 112 form- und/oder kraftschlüssig mit dem Crimpverbinder 11 verbunden. Dies ermöglicht eine einfache und zuverlässige Montage.

### Bezuaszeichenliste

- 1: Fahrzeug
- 2: Heckklappe
- 3: Schweller
- 4: Stoßfänger
- 5: Türgriff
- 9: Benutzer

- 10: Prüfverbindungsanpassung, Verbindungsanpassung, Crimp
- 11: Verbindungsmittel, Crimpverbinder
- 12: Verbindungsstelle
- 15: erster Leiter
- 16: zweiter Leiter

- 20: Auswerteverbindungsanpassung

- 100: Sensorvorrichtung
- 110: Sensorelement
- 111: Innenleiterelement, Seele
- 112: Außenleiterelement, Schirm
- 115: erstes Ende
- 116: zweites Ende

- 120: Isolationselement
- 121: erstes Isolationselement
- 122: zweites Isolationselement, Schutzmantel

- 200: Steuergerät
- 210: Auswertevorrichtung
- 220: Steuergeräteleitung
- 230: Verbindungsschnittstelle, Stecker

- 300: System

## Patentansprüche

1. Sensorvorrichtung (100) zur kapazitiven Erfassung einer Benutzerhandlung bei einem Fahrzeug (1), mit einem Sensorelement (110), welches als elektrisches Leitungselement ausgeführt ist, wobei das Sensorelement (110) aufweist:
- ein elektrisch leitendes Außenleiterelement (112),
- wenigstens ein Isolationselement (120) zur elektrischen Isolierung des Außenleiterelements (112),
- eine Auswerteverbindungsanpassung (20) an dem Außenleiterelement (112) zur elektrisch leitenden Verbindung des Außenleiterelements (112) mit einer Auswertevorrichtung (210) des Fahrzeuges (1), wodurch die Erfassung durchführbar ist,
wobei
eine Prüfverbindungsanpassung (10) an dem Außenleiterelement (112) vorgesehen ist, um einen Funktionstest der Sensorvorrichtung (100) anhand eines elektrischen Stromkreises mit dem Außenleiterelement (112) zu prüfen, wobei das Sensorelement (110) ein elektrisch leitendes Innenleiterelement (111) aufweist, und das wenigstens eine Isolationselement (120) das Innenleiterelement (111) zur elektrischen Isolierung umgibt, wobei das Innenleiterelement (111) vollständig und allseits elektrisch isoliert ist.

2. Sensorvorrichtung (100) nach Anspruch 1,
**dadurch gekennzeichnet,**
**dass** die Auswerteverbindungsanpassung (20) Teil der Prüfverbindungsanpassung (10) ist, wobei die Auswerteverbindungsanpassung (20) wenigstens oder ausschließlich einen ersten Leiter (15) aufweist, um die Auswertevorrichtung (210) mit dem Außenleiterelement (112) zur Auswertung der Erfassung zu verbinden und die Prüfverbindungsanpassung (10) wenigstens oder ausschließlich einen zweiten Leiter (16) und den ersten Leiter (15) aufweist, um die Auswertevorrichtung (210) mit dem Außenleiterelement (112) zu verbinden und den Stromkreis zur Durchführung des Funktionstests bereitzustellen.

3. Sensorvorrichtung (100) nach Anspruch 1 oder 2,
**dadurch gekennzeichnet,**
**dass** die Prüfverbindungsanpassung (10) zumindest ein Verbindungsmittel (11), vorzugsweise einen Crimpverbinder (11), aufweist, um das Außenleiterelement (112) elektrisch mit der Auswertevorrichtung (210) zu verbinden, sodass durch die Auswertevorrichtung (210) der Funktionstest durchführbar ist, wobei vorzugsweise der Funktionstest als eine Verbindungsprüfung ausgeführt ist.

4. Sensorvorrichtung (100) nach einem der vorhergehenden Ansprüche,
**dadurch gekennzeichnet,**
**dass** das Sensorelement (110) als elektrisches Kabel ausgebildet ist und vorzugsweise ein Innenleiterelement (111) als Seele (111) und das Außenleiterelement (112) als Schirm (112) aufweist und/oder dass das Außenleiterelement (112) als ein elektrisch leitfähiges Drahtgeflecht ausgebildet ist.

5. Sensorvorrichtung (100) nach einem der vorhergehenden Ansprüche,
**dadurch gekennzeichnet,**
**dass** das Sensorelement (110) einen konzentrischen Aufbau aufweist, wobei vorzugsweise das Außenleiterelement (112) koaxial zu einem Innenleiterelement (111) des Sensorelements (110) angeordnet ist.

6. Sensorvorrichtung (100) nach einem der vorhergehenden Ansprüche,
**dadurch gekennzeichnet,**
**dass** das Isolationselement (120) ein erstes Isolationselement (121), insbesondere für das Innenleiterelement (111), und ein zweites Isolationselement (122), insbesondere für das Außenleiterelement (112), aufweist, welche konzentrisch angeordnet sind.

7. Sensorvorrichtung (100) nach einem der vorhergehenden Ansprüche,
**dadurch gekennzeichnet,**
**dass** das Sensorelement (110) eine längliche Erstreckung entlang einer Längsachse zwischen einem ersten Ende (115), welches vorzugsweise der Auswertevorrichtung (210) zugewandet ist, und einem zweiten Ende (116), welches vorzugsweise der Auswertevorrichtung abgewandt ist, aufweist, und die Prüfverbindungsanpassung (10) und/oder Auswerteverbindungsanpassung (20) ausschließlich an einem der Enden am Sensorelement (110) vorgesehen sind, und vorzugsweise ein erster Leiter (15) und ein zweiter Leiter (16) nur an einem der Enden mit dem Außenleiterelement (112) verbunden sind, sodass bevorzugt das zweite Ende als freies Ende elektrisch unverbunden ist.

8. Sensorvorrichtung (100) nach einem der vorhergehenden Ansprüche,
**dadurch gekennzeichnet,**
**dass** das Außenleiterelement (112), und vorzugsweise ein Innenleiterelement (111), sich entlang der länglichen Erstreckung des Sensorelements (110) erstrecken, sodass bevorzugt das Innenleiterelement (111) und das Außenleiterelement (112) parallel zueinander verlaufen.

9. System (300) zur kapazitiven Erfassung einer Benutzerhandlung bei einem Fahrzeug (1), umfassend:
- eine Auswertevorrichtung (210) zur Auswertung des Sensorelements (110),
- eine Sensorvorrichtung (100) nach Anspruch 1.

10. System (300) nach Anspruch 9,
**dadurch gekennzeichnet,**
**dass** eine elektrische Verbindungsschnittstelle (230), vorzugsweise ein Stecker (230), elektrisch mit der Auswertevorrichtung (210) verbunden ist und ein erster und zweiter Leiter (15, 16) des Außenleiterelements (112) über die Verbindungsschnittstelle (230) mit der Auswertevorrichtung (210) elektrisch verbunden ist und/oder dass ein erster Leiter (15) benachbart zu einem zweiten Leiter (16) mit dem Außenleiterelement (112) elektrisch verbunden ist, insbesondere in einem Abstand von maximal 1 mm bis 40 mm, vorzugsweise 2 mm bis 30 mm, bevorzugt 5 mm bis 20 mm, wodurch das Außenleiterelement (112) in einen Strompfad seriell zum ersten und zweiten Leiter (15, 16) integriert ist.

11. System (300) nach einem der Ansprüche 9 bis 10,
**dadurch gekennzeichnet,**
**dass** die Sensorvorrichtung (100) nach einem der Ansprüche 2 bis 8 ausgebildet ist.

12. Fahrzeug (1) mit einem System (300) zur kapazitiven Erfassung einer Benutzerhandlung nach einem der Ansprüche 9 bis 11.

13. Fahrzeug (1) nach Anspruch 12,
**dadurch gekennzeichnet,**
**dass** das Sensorelement (110) in einem Stoßfänger (4) des Fahrzeuges (1) angeordnet ist, um eine Fußbewegung eines Benutzers (9) im Heckbereich des Fahrzeuges (1) zu erfassen.

14. Verfahren zum Betreiben einer kapazitiven Sensorvorrichtung (100) gemäß einem der Ansprüche 1 bis 8 bei einem Fahrzeug (1),
**wobei die nachfolgenden Schritte vorgesehen sind:**
- Durchführen einer Verbindungsprüfung bei der Sensorvorrichtung (100) durch eine Auswertevorrichtung (210), wobei ein elektrischer Strom über wenigstens zwei Leiter (15, 16) durch ein Außenleiterelement (112) eines Sensorelements (110) der Sensorvorrichtung (100) geleitet wird,
- Durchführen einer Erfassung einer Benutzerhandlung bei dem Fahrzeug (1), wobei hierzu eine elektrische Auswertung anhand eines der Leiter (15, 16) und des Außenleiterelements (112) erfolgt.

15. Verfahren nach Anspruch 14,
**dadurch gekennzeichnet,**
**dass** der nachfolgende Schritt vor dem Durchführen der Verbindungsprüfung vorgesehen ist:
- Verbinden des Sensorelements (110) der Sensorvorrichtung (100) über eine Verbindungsschnittstelle (230) mit einer Auswertevorrichtung (210) des Fahrzeuges (1) und/oder dass eine Sensorvorrichtung (100) nach einem der Ansprüche 1 bis 10 und/oder ein System (300) nach einem der Ansprüche 11 bis 14 und/oder ein Fahrzeug (1) nach einem der Ansprüche 15 oder 16 betrieben wird.

## Claims

1. Sensor device (100) for capacitive detection of a user action in a vehicle (1), having a sensor element (110) which is designed as an electrical line element, the sensor element (110) having:
- an electrically conductive outer conductor element (112),
- at least one insulation element (120) for electrically insulating the outer conductor element (112),
- an evaluation connection adaptation (20) on the outer conductor element (112) for electrically conductively connecting the outer conductor element (112) to an evaluation device (210) of the vehicle (1), whereby the detection is feasible,
wherein a test connection adaptation (10) is provided on the outer conductor element (112) to test a functional test of the sensor device (100) based on an electrical circuit with the outer conductor element (112), wherein
the sensor element (110) comprises an electrically conductive inner conductor element (111), and the at least one insulation element (120) surrounds the inner conductor element (111) for electrical insulation, wherein the inner conductor element (111) is electrically insulated completely and on all sides.

2. Sensor device (100) according to claim 1,
**characterized in that**
the evaluation connection adaptation (20) is part of the test connection adaptation (10), the evaluation connection adaptation (20) comprising at least or exclusively a first conductor (15) to connect the evaluation device (210) to the outer conductor element (112) for evaluation of the detection, and the test connection adaption (10) comprises at least or exclusively a second conductor (16) and the first conductor (15) to connect the evaluation device (210) to the outer conductor element (112) and to provide the circuit for performing the functional test.

3. Sensor device (100) according to claim 1 or 2,
**characterized in that**
the test connection adaptation (10) has at least one connection means (11), preferably a crimp connector (11), for electrically connecting the outer conductor element (112) to the evaluation device (210), so that the functional test can be carried out by the evaluation device (210), the functional test preferably being designed as a connection test.

4. Sensor device (100) according to any one of the preceding claims,
**characterized in that**
the sensor element (110) is designed as an electric cable and preferably has an inner conductor element (111) as a core (111) and the outer conductor element (112) as a shield (112) and/or **in that** the outer conductor element (112) is designed as an electrically conductive wire mesh.

5. Sensor device (100) according to any one of the preceding claims,
**characterized in that**
the sensor element (110) has a concentric structure, the outer conductor element (112) preferably being arranged coaxially with an inner conductor element (111) of the sensor element (110).

6. Sensor device (100) according to any one of the preceding claims,
**characterized in that**
the insulation element (120) has a first insulation element (121), in particular for the inner conductor element (111), and a second insulation element (122), in particular for the outer conductor element (112), which are arranged concentrically.

7. Sensor device (100) according to any one of the preceding claims,
**characterized in that**
the sensor element (110) has an elongated extension along a longitudinal axis between a first end (115), which preferably faces the evaluation device (210), and a second end (116), which preferably faces away from the evaluation device and the test connection adaptation (10) and/or evaluation connection adaptation (20) are provided exclusively at one of the ends on the sensor element (110), and preferably a first conductor (15) and a second conductor (16) are connected to the outer conductor element (112) only at one of the ends, so that preferably the second end is electrically unconnected as a free end.

8. Sensor device (100) according to any one of the preceding claims,
**characterized in that**
the outer conductor element (112), and preferably an inner conductor element (111), extend along the longitudinal extension of the sensor element (110), so that preferably the inner conductor element (111) and the outer conductor element (112) extend parallel to each other.

9. A system (300) for capacitively detecting a user action on a vehicle (1), comprising:
- an evaluation device (210) for evaluating the sensor element (110),
- a sensor device (100) according to claim 1.

10. System (300) according to claim 9,
**characterized in that**
an electrical connection interface (230), preferably a plug (230), is electrically connected to the evaluation device (210), and a first and second conductor (15, 16) of the outer conductor element (112) is electrically connected to the evaluation device (210) via the connection interface (230), and/or **in that** a first conductor (15) adjacent to a second conductor (16) is electrically connected to the outer conductor element (112) in particular at a distance of at most 1 mm to 40 mm, preferably 2 mm to 30 mm, preferably 5 mm to 20 mm, whereby the outer conductor element (112) is integrated in a current path in series with the first and second conductors (15, 16).

11. The system (300) according to any one of claims 9 to 10,
**characterized in that**
the sensor device (100) is formed according to one of the claims 2 to 8.

12. A vehicle (1) comprising a system (300) for capacitively detecting a user action according to any one of claims 9 to 11.

13. Vehicle (1) according to claim 12,
**characterized in that**
the sensor element (110) is arranged in a bumper (4) of the vehicle (1) to detect a foot movement of a user (9) in the rear area of the vehicle (1).

14. A method of operating a capacitive sensor device (100) according to any one of claims 1 to 8 on a vehicle (1),
**wherein the following steps are provided:**
- Performing a connection test in the sensor device (100) by an evaluation device (210), wherein an electric current is conducted via at least two conductors (15, 16) through an outer conductor element (112) of a sensor element (110) of the sensor device (100),
- Carrying out a detection of a user action on the vehicle (1), with an electrical evaluation being carried out for this purpose using one of the conductors (15, 16) and the external conductor element (112).

15. The method of claim 14,
**characterized in that**
the following step is provided before performing the connection test:
- Connecting the sensor element (110) of the sensor device (100) via a connection interface (230) to an evaluation device (210) of the vehicle (1) and/or that a sensor device (100) according to one of claims 1 to 10 and/or a system (300) according to one of claims 11 to 14 and/or a vehicle (1) according to one of claims 15 or 16 is operated.

## Revendications

1. Dispositif de détection (100) pour la détection capacitive d'une action d'utilisateur sur un véhicule (1), avec un élément de détection (110) qui est réalisé sous forme d'élément conducteur électrique, l'élément de détection (110) présentant
- un élément conducteur extérieur (112) électriquement conducteur,
- au moins un élément d'isolation (120) pour isoler électriquement l'élément conducteur extérieur (112),
- une adaptation de connexion d'évaluation (20) sur l'élément conducteur extérieur (112) pour la connexion électriquement conductrice de l'élément conducteur extérieur (112) avec un dispositif d'évaluation (210) du véhicule (1), grâce à quoi la détection est réalisable,
dans lequel une adaptation de connexion de test (10) est prévue sur l'élément conducteur extérieur (112) pour vérifier un test de fonctionnement du dispositif de détection (100) à l'aide d'un circuit électrique avec l'élément conducteur extérieur (112), dans lequel
l'élément de détection (110) présente un élément conducteur intérieur (111) électriquement conducteur, et l'au moins un élément d'isolation (120) entoure l'élément conducteur intérieur (111) pour l'isolation électrique, l'élément conducteur intérieur (111) étant complètement isolé électriquement de tous côtés.

2. Dispositif de détection (100) selon la revendication 1,
**caractérisé en ce que**
l'adaptation de connexion d'évaluation (20) fait partie de l'adaptation de connexion de test (10), l'adaptation de connexion d'évaluation (20) présentant au moins ou exclusivement un premier conducteur (15), pour relier le dispositif d'évaluation (210) à l'élément conducteur extérieur (112) pour évaluer la détection et l'adaptation de connexion de test (10) comprend au moins ou exclusivement un deuxième conducteur (16) et le premier conducteur (15) pour relier le dispositif d'évaluation (210) à l'élément conducteur extérieur (112) et pour fournir le circuit électrique pour effectuer le test de fonctionnement.

3. Dispositif de détection (100) selon la revendication 1 ou 2,
**caractérisé en ce que**
l'adaptation de connexion de test (10) présente au moins un moyen de connexion (11), de préférence un connecteur à sertir (11), pour relier électriquement l'élément conducteur extérieur (112) au dispositif d'évaluation (210), de sorte que le test de fonctionnement peut être réalisé par le dispositif d'évaluation (210), le test de fonctionnement étant de préférence réalisé comme un test de connexion.

4. Dispositif de détection (100) selon l'une des revendications précédentes,
**caractérisé en ce que**
l'élément de détection(110) est réalisé sous la forme d'un câble électrique et présente de préférence un élément conducteur intérieur (111) comme âme (111) et l'élément conducteur extérieur (112) comme écran (112) et/ou **en ce que** l'élément conducteur extérieur (112) est réalisé sous la forme d'un treillis métallique électriquement conducteur.

5. Dispositif de détection (100) selon l'une des revendications précédentes,
**caractérisé en ce que**
l'élément de détection (110) présente une structure concentrique, l'élément conducteur extérieur (112) étant de préférence disposé coaxialement à un élément conducteur intérieur (111) de l'élément de détection (110).

6. Dispositif de détection (100) selon l'une des revendications précédentes,
**caractérisé en ce que**
l'élément d'isolation (120) présente un premier élément d'isolation (121), en particulier pour l'élément conducteur intérieur (111), et un deuxième élément d'isolation (122), en particulier pour l'élément conducteur extérieur (112), qui sont disposés de manière concentrique.

7. Dispositif de détection (100) selon l'une des revendications précédentes,
**caractérisé en ce que**
l'élément de détection (110) présente une extension longitudinale le long d'un axe longitudinal entre une première extrémité (115), qui est de préférence tournée vers le dispositif d'évaluation (210), et une deuxième extrémité (116), qui est de préférence opposée au dispositif d'évaluation, et l'adaptation de la connexion de test (10) et/ou l'adaptation de la connexion d'évaluation (20) sont prévues exclusivement à l'une des extrémités sur l'élément de détection (110), et de préférence un premier conducteur (15) et un deuxième conducteur (16) ne sont reliés à l'élément conducteur extérieur (112) qu'à l'une des extrémités, de sorte que de préférence la deuxième extrémité n'est pas reliée électriquement en tant qu'extrémité libre.

8. Dispositif de détection (100) selon l'une des revendications précédentes,
**caractérisé en ce que**
l'élément conducteur extérieur (112), et de préférence un élément conducteur intérieur (111), s'étendent le long de l'extension longitudinale de l'élément de détection (110), de sorte que de préférence l'élément conducteur intérieur (111) et l'élément conducteur extérieur (112) s'étendent parallèlement l'un à l'autre.

9. Système (300) pour la détection capacitive d'une action de l'utilisateur dans un véhicule (1), comprenant :
- un dispositif d'évaluation (210) pour évaluer l'élément de détection (110),
- un dispositif de détection (100) selon la revendication 1.

10. Système (300) selon la revendication 9,
**caractérisé en ce que**
une interface de connexion électrique (230), de préférence une fiche (230), est reliée électriquement au dispositif d'évaluation (210) et un premier et un deuxième conducteur (15, 16) de l'élément conducteur extérieur (112) sont reliés électriquement au dispositif d'évaluation (210) par l'intermédiaire de l'interface de connexion (230) et/ou **en ce qu'**un premier conducteur (15) adjacent à un deuxième conducteur (16) est relié électriquement à l'élément conducteur extérieur (112), notamment à une distance maximale de 1 mm à 40 mm, de préférence de 2 mm à 30 mm, de préférence de 5 mm à 20 mm, l'élément conducteur extérieur (112) étant ainsi intégré dans un trajet de courant en série avec le premier et le deuxième conducteur (15, 16).

11. Système (300) selon l'une quelconque des revendications 9 à 10,
**caractérisé en ce que**
le dispositif de détection (100) est réalisé selon l'une des revendications 2 à 8.

12. Véhicule (1) comprenant un système (300) de détection capacitive d'une action de l'utilisateur selon l'une quelconque des revendications 9 à 11.

13. Véhicule (1) selon la revendication 12,
**caractérisé en ce que**
l'élément de détection (110) est disposé dans un pare-chocs (4) du véhicule (1) pour détecter un mouvement de pied d'un utilisateur (9) dans la zone arrière du véhicule (1).

14. Procédé de mise en oeuvre d'un dispositif de détection capacitif (100) selon l'une des revendications 1 à 8 sur un véhicule (1),
**dans lequel prévoit les étapes suivantes** :
- Réalisation d'un contrôle de connexion sur le dispositif de détection (100) par un dispositif d'évaluation (210), dans lequel un courant électrique est conduit par au moins deux conducteurs (15, 16) à travers un élément conducteur extérieur (112) d'un élément de détection (110) du dispositif de détection (100),
- Effectuer une détection d'une action d'utilisateur dans le véhicule (1), une évaluation électrique étant effectuée à cet effet à l'aide de l'un des conducteurs (15, 16) et de l'élément conducteur extérieur (112).

15. Procédé selon la revendication 14,
**caractérisé en ce que**
l'étape suivante est prévue avant l'exécution du contrôle de connexion :
- Relier l'élément de détection (110) du dispositif de détection(100) par une interface de liaison (230) à un dispositif d'évaluation (210) du véhicule (1) et/ou **en ce qu'**on exploite un dispositif de détection(100) selon l'une des revendications 1 à 10 et/ou un système (300) selon l'une des revendications 11 à 14 et/ou un véhicule (1) selon l'une des revendications 15 ou 16.
